# EUROPÄISCHE PATENTSCHRIFT

(11) **EP 0 939 978 B1**
(45) Veröffentlichungstag und Bekanntmachung des Hinweises auf die Patenterteilung: **10.10.2001**
(21) Anmeldenummer: 97951154.0
(22) Anmeldetag: 10.11.1997
(51) Int. Cl.: H01S 3/23, H01S 3/0941, H01S 3/04, H01S 3/10

(54) **LASER- UND VERSTÄRKERSYSTEM ZUR ERZEUGUNG EINFREQUENTER LASERSTRAHLUNG**
LASER SYSTEM AND AMPLIFYING SYSTEM TO PRODUCE SINGLE-FREQUENCY LASER RADIATION
SYSTEME LASER ET AMPLIFICATEUR POUR PRODUIRE UN FAISCEAU LASER A UNE SEULE FREQUENCE

(30) Priorität: 19.11.1996 DE 19647677
(43) Veröffentlichungstag der Anmeldung: 08.09.1999
(73) Patentinhaber: Contraves Space AG, 8052 Zürich (CH)
(72) Erfinder: SCHMITT, Nikolaus, D-80797 München (DE); KÖNIGER, Max, D-81479 München (DE); UNGER, Peter, D-89081 Ulm (DE); PRIBIL, Klaus, CH-8152 Glattbrugg (CH)
(74) Vertreter: Hotz, Klaus, Dipl.-El.-Ing./ETH
(86) Internationale Anmeldenummer: EP9706219
(87) Internationale Veröffentlichungsnummer: WO9822999

(56) Entgegenhaltungen:
- US-A- 5 446 750
- US-A- 5 530 582
- US-A- 5 539 571
- PATENT ABSTRACTS OF JAPAN vol. 017, no. 276 (E-1372), 27.Mai 1993 & JP 05 013891 A (MITSUBISHI ELECTRIC CORP), 22.Januar 1993,
- BALL G A ET AL: "60 MW 1.5 M SINGLE-FREQUENCY LOW-NOISE FIBER LASER MOPA" IEEE PHOTONICS TECHNOLOGY LETTERS, Bd. 6, Nr. 2, 1.Februar 1994, Seiten 192-194, XP000439747
- ZYSSET B ET AL: "HIGH REPETITION RATE FEMTOSECOND DYE AMPLIFIER USING A LASER DIODE PUMPED NEODYMIUM:YAG LASER" APPLIED PHYSICS LETTERS, Bd. 54, Nr. 6, 6.Februar 1989, Seiten 496-498, XP000027416
- PATENT ABSTRACTS OF JAPAN vol. 095, no. 005, 30.Juni 1995 & JP 07 038202 A (FUJI PHOTO FILM CO LTD), 7.Februar 1995,
- PATENT ABSTRACTS OF JAPAN vol. 017, no. 687 (E-1478), 16.Dezember 1993 & JP 05 235441 A (SONY CORP), 10.September 1993,
- PATENT ABSTRACTS OF JAPAN vol. 016, no. 188 (E-1198), 7.Mai 1992 & JP 04 025083 A (MITSUBISHI ELECTRIC CORP), 28.Januar 1992,
- PATENT ABSTRACTS OF JAPAN vol. 018, no. 464 (E-1598), 29.August 1994 & JP 06 152014 A (SONY CORP), 31.Mai 1994,

## Beschreibung

Die Erfindung betrifft ein einfrequentes Laser- und Verstärkersystem.

Für viele Anwendungen von Lasern in Kommunikationsaufgaben werden heute einfrequente Laser benötigt. Während in der Kommunikation über Glasfasern insbesondere Laserdioden im Wellenlängenbereich um 1.3 µm oder 1,5µm üblich sind, um eine besonders hohe Transmission bzw. eine besonders geringe Dispersion in der Glasfaser zu erlangen, werden für Freistrahl-Laserkommunikationsstrecken beispielsweise im Weltraum zwischen Satelliten auch Laser bei kürzerer Wellenlänge, beispielsweise bei 1.06 µm verwendet. Hier liegen die spezifischen Anforderungen weniger bei der Wellenlänge der Laserstrahlung. Wesentlich wichtiger ist hier die spektrale Schmalbandigkeit der Laserquellen, da hier zur Übertragung sehr hoher Datenraten (typisch 650 MBit/s und mehr) kohärente Übertragungssysteme verwendet werden.

Typische Linienbreitenanforderungen liegen hier bei < 10 kHz oder noch weniger und einem entsprechend geringen Frequenzrauschen (Jitter), was mit Halbleiterlasern bei konstantem Betrieb im allgemeinen nicht erreicht wird. Hier werden hingegen Festkörperlaser, und zwar aus Effizienzgründen vorzugsweise diodengepumpte Festkörperlaser eingesetzt. Diese verfügen über einen um etwa zwei Größenordnungen geringeren Koeffizienten für die Änderung der optischen Resonatorlänge und damit der Frequenz der Laserstrahlung mit der Temperatur. Der Koeffizient beträgt bei Halbleiter-Laserdioden beispielsweise typisch 0,3 nm/°C, entsprechend bei 830 nm von 130 GHz/°C gegenüber typisch 3,5 GHz/°C bei Nd:YAG-Lasern.

Ein Laser- und Verstärkersystem mit einem Festkörperlaser und einem Halbleiterverstärker, welcher durch Wahl von Material und Struktur auf eine Emissionswellenlänge von 1.06 µm angepasst ist, ist beispielsweise aus der Patentschrift US 5 539 571 A bekannt. Um eine grosse Leistung zusammen mit einer kleinen Distorsion zu erreichen, wird dieses System differential gepumpt. Somit wird ein gegenüber der eingekoppelten Laserstrahlung verstärkter Ausgangsstrahl erzeugt. In diesem bekannten System wird zudem eine Leistungsmodulation der Ausgangsstrahlung durch elektrische Ansteuerung eines Bereiches des Halbleiterverstärkers erzeugt.

Ein Sendelaser für eine solche Intersatelliten-Übertragungsstrecke benötigt eine Ausgangsleistung von typisch> 1W kontinuierlicher Leistung bei gleichzeitiger Erfüllung der Linienbreiten-Spezifikation. Weiter muß der Laser phasenmoduliert werden. Modulatoren nach dem Stande der Technik arbeiten jedoch nur bis zu Leistungen von wenigen 100 mW, so dass die Sendelaserleistung zunächst auf diesen Wert beschränkt bleiben muß und nach der Modulation auf die geforderte Nennleistung verstärkt werden muß.

Nach dem Stande der Technik werden hier ebenfalls diodengepumpte Festkörper-Verstärkeranordnungen verwendet, die ähnlich wie diodengepumpte Festkörperlaser aufgebaut sind, jedoch unterhalb der Laserschwelle betrieben werden. Diese Verstärkeranordnungen sind jedoch relativ aufwendig und ineffizient.

Bei einfachen Verstärkeranordnungen mit nur einem oder zwei Durchgängen werden hier Verstärkungsfaktoren von typisch 1.5-2 (W. Seelert et al. OSA Proc. on Advanced Solid-State Lasers (Hilton Head, 1991), Bd.10 (1991) 261)erreicht, so dass zur Erzielung einer Ausgangsleistung von 1 W aus 100 mW Oszillatorleistung aus dem Phasenmodulator vier oder mehr Verstärkerstufen benötigt werden.

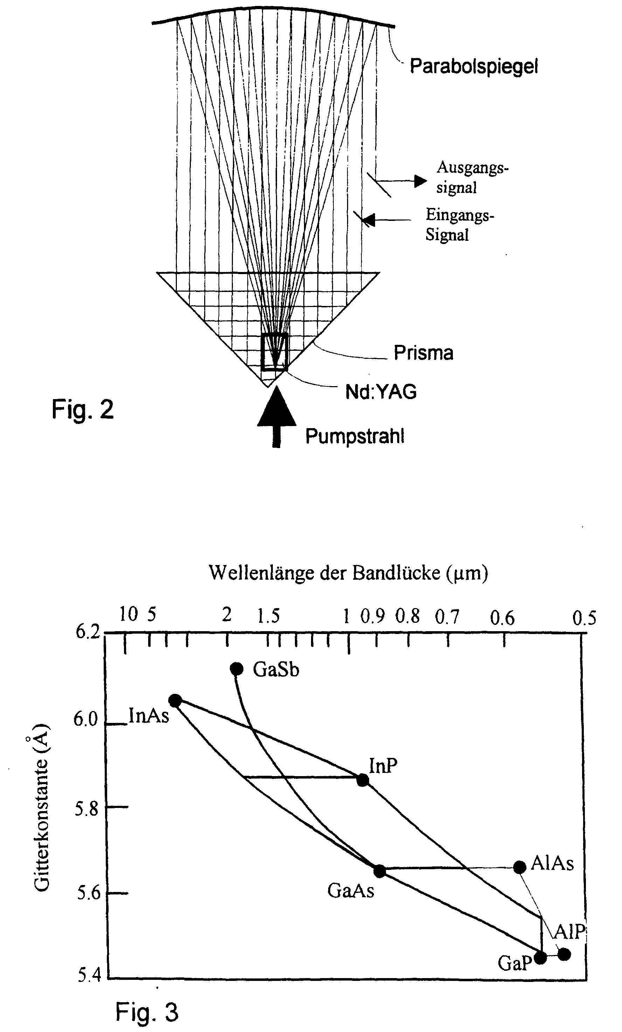

Eine wesentlich höhere Verstärkung von bis über 50dB konnten dagegen nur mit Multipath-Verstärkeranordnungen erreicht werden (Kane et. al., SPIE Vol 2381, S. 273; vergl. Fig 2). Diese Anordnungen sind relativ aufwendig und unterliegen aufgrund der komplizierten Strahlführung starken thermischen Fluktuationen. Auch ist die Energiebilanz für solche Verstärkeranordnungen relativ schlecht (hier ~ 9.4 W elektrischer Eingangsleistung + 30 mW Oszillatorleistung führte zu 835 mW Ausgangsleistung, elektrisch- zu optischer Verstärkereffizienz von kleiner 9 %W). Diese Anordnungen lassen sich weiter auch nicht wesentlich miniaturisieren.

Besonders einfach sind Halbleiter-Laserverstärker, die ähnlich wie Halbleiter-Laserdioden aus einer epitaktischen Schichtfolge von beispielsweise GaAs, GaAlAs, InGaAs oder InGaAsP aufgebaut sind. Gegenüber Laserdioden verfügen solche Halbleiterverstärker auf beiden Endflächen über Antireflex-Beschichtungen, so dass das Halbleiterelement weit unter der für Laserbetrieb als Oszillator erforderlichen Schwellenleistung betrieben wird. Koppelt man nun auf einer Seite des Halbleiterelementes Laserstrahlung ein, so wird diese im elektrisch gepumpten Halbleitermaterial verstärkt. Solche Anordnungen sind ebenfalls seit vielen Jahren bekannt und beispielsweise in R. Waarts et.al., Electron. Lett. 26 (1990)1926 beschrieben. Zur Erzeugung von Strahlung hoher Strahlqualität sind besondere Strukturierungen des Halbleiterverstärkers üblich, beispielsweise Breitstreifen- oder Trapezstrukturen, vergl. .J. N. Walpole et. al., SPIE Bd. 1850, Laser Diode Technology and Applications V (1993)51.

Üblicherweise werden als Laseroszillator, dessen Strahlung verstärkt werden soll, ebenfalls Halbleiterlaserdioden aus gleichem Material eingesetzt. Solche Oszillator-Verstärker-Strukturen (MOPA von Master-Oscillator-Power Amplifier) sind vorzugsweise auf demselben epitaktischen Substrat aufgebaut und durch entsprechende Strukturierung in ihrer Funktion getrennt. Derartige Bauteile sind beispielsweise in R. Parke, CLEO 93, Tech. Digest, Beitrag CTul4 (1993)108 beschrieben und werden kommerziell angeboten. Diese Elemente erfüllen jedoch nicht die Spezifikationen bezüglich Linienbreite und Frequenzrauschen (Jitter).

Diese MOPA-Strukturen sind jedoch für die genannten Aufgaben der kohärenten Kommunikation ungeeignet. Sowohl die räumliche Strahlqualität als auch insbesondere die hohen Linienbreiten lassen ein kohärentes Phasenrasten (phase locking) nicht zu.

Es ist Aufgabe der Erfindung, ein einfaches, effizientes und miniaturisiertes Laser und Verstärkersystem aufzuzeigen, welches die Erzeugung schmalbandiger Laserstrahlung im Wattbereich ermöglicht.

Diese Aufgabe wird durch die in den Ansprüchen und den Figuren aufgezeigten Maßnahmen gelöst.

Es zeigen:
Fig. 1 das grundlegende Schema einer erfindungsgemäßen Anordnung von diodengepumptem Einfrequenz-Festkörperlaser - hier: Mikro-kristall-Laser- und Halbleiter-Verstärker,
Fig. 2 einen Multipath-Festkörperverstärker nach dem Stande der Technik mit einer Verstärkung von 52 dB (entnommen aus Kane et. al., SPIE Vol. 2381, S.273 f),
Fig. 3 ein Schema zur Zuordnung der geeigneten Halbleiter-Materialien für die jeweiligen Wellenlängenbereich diodengepumpten Festkörperlaser,
Fig. 4 ein typisches Verstärkungsprofil eines InGaAs-Halbleiterverstärkers nach dem Stande der Technik, hier mit Verstärkungsschwerpunkt um 960 nm (entnommen aus Ebeling/Unger, Zusammenfassung zum 2. Zwischenbericht F+E-Förderkennzeichen 13 N 6374/3, Universität Ulm),
Fig. 5 eine typische Verstärkungskurve eines Halbleiterverstärkers nach dem Stande der Technik (entnommen ebenda),
Fig. 6 eine typische Schichtenfolge einer InGaAs-Verstärkerstruktur,
Fig. 7 die Beziehung von spektralem Verstärkungsschwerpunkt und Trägerdichte für die Struktur aus Fig. 6 (entnommen ebenda),
Fig. 8a eine erfindungsgemäße Anordnung von Festkörperlaser und Halbleiterverstärker auf derselben Wärmesenke,
Fig. 8b eine erfindungsgemäße Anordnung von abstimmbarem Festkörperlaser und Halbleiterverstärker auf thermisch getrennten Wärmesenken bzw. Temperaturniveaus unter beispielhafter Verwendung eines Peltierelementes,
Fig. 8c eine erfindungsgemäße Anordnung von abstimmbarem Festkörperlaser und Halbleiterverstärker auf thermisch getrennten Wärmesenken bzw. Temperaturniveaus unter beispielhafter Verwendung eines thermisch schlecht leitenden Materials,

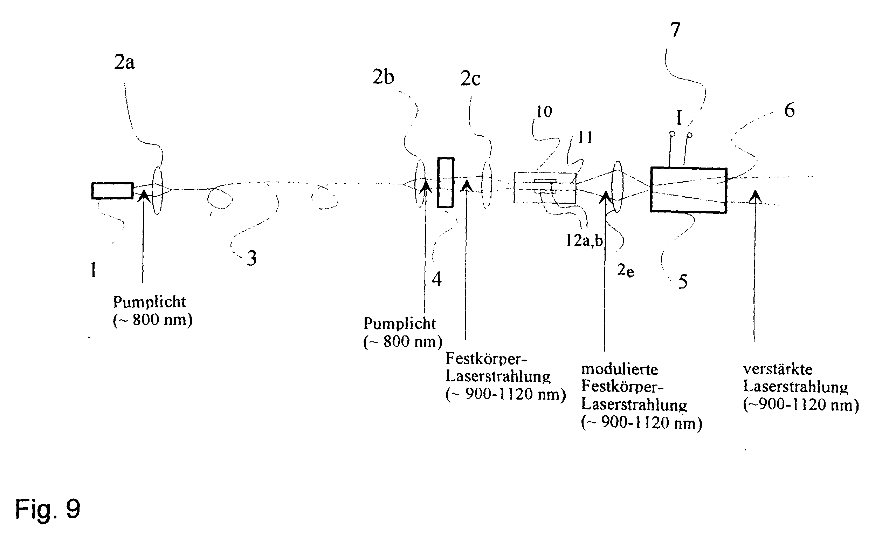

Fig. 9 eine erfindungsgemäße Anordnung von Festkörperlaser und Halbleiterverstärker mit zwischen die beiden Elemente eingebrachtem Modulator,
Fig. 10 eine erfindungsgemäße Anordnung von Festkörperlaser, Modulator und Halbleiterverstärker auf derselben Grundplatte, und
Fig. 11 eine erfindungsgemäße Anordnung von Pumplaserdiode, Festkörperlaser, ggfs. Modulator und Halbleiterverstärker und ggfs. erforderlichen Linsen auf derselben Grundplatte.

Es wird vorgeschlagen, die Strahlung eines leistungsschwachen diodengepumpten Festkörperlasers (etwa Nd:YAG), vorzüglich eines schmalbandigen kontinuierlich emittierenden Festkörperlasers wie etwa Mikrokristall-Laser (oder auch monolithischer Ringlaser), mittels eines Halbleiter-Verstärkers zu verstärken.

Besonders einfache einfrequente diodengepumpte Festkörperlaser stellen dabei Mikrokristall-Laser dar, welche aufgrund ihrer geringen Resonatorlänge inhärent einfrequent emittieren (vergl. z.B. Demtröder, Laser Spectroscopy,Springer-Verlag 1982, S.286, oder N. Schmitt, Abstimmbare Mikrokristall-Laser, Shaker-Verlag 1995). Die Ausgangsleistung solcher Laser liegt typisch bei 30-50 mW. Die Linienbreiten sind hier jedoch ausgesprochen schmal.

Der grundlegende Erfindungsgedanke beruht auf der Verstärkung der Laserstrahlung eines schmalbandigen, diodengepumpten Festkörperlasers, beispielsweise eines Mikrokristall-Lasers vorzugsweise aus Seltenerd- oder Übergangsmetalldotierten Kristall- oder Glasmaterialien bestehend, durch ein Halbleiter-Verstärkerelement, welches durch die Wahl des Epitaxiemateriales wie auch dessen Strukturierung auf die Emissionswellenlänge des Festkörperlasers angepaßt ist. So eignen sich beispielsweise für Festkörperlaser, welche im Bereich zwischen 900 und 1100 nm emittieren, insbesondere Materialkombinationen aus GaAlAs, GaAlAs, InGaAs und/oder GaAsP. Fig. 3 veranschaulicht, welches Materialsystem hierbei für welchen Wellenlängenbereich besonders geeignet ist: Die (dicken) Verbindungslinien zwischen den III-V-Materialverbindungen (binäre Verbindungen der Elemente der Gruppe III und V des Periodensystemes) bezeichnen hier die sogenannten tertiären Verbindungen (also Verbindungen aus zwei Elementen der Gruppe III und einem Element der Gruppe V, Beispiel InAs + GaAs => InGaAs); die Punkte kennzeichnen die binären Verbindungen, entlang der Linie ändert sich die Wellenlänge und die Gitterkonstante der tertiären Verbindung entsprechend dem jeweiligen prozentualen Anteil der beiden binären Verbindungen. Die Bereiche zwischen diesen Linien kennzeichnen die quaternären Verbindungen (also zwei Elemente der Gruppe III plus zwei Verbindungen der Gruppe V, Beispiel InGaAsP). Die waagerechten Linien kennzeichnen hier die Verbindungen mit gleicher Gitterkonstante, bei den nicht waagerechten Linien sind die Gitter der Komposition verspannt (strained-layer). Die dünnen Verbindungslinien beispielsweise zwischen GaP und AIP und AIP und AlAs kennzeichnen indirekte Halbleiterübergänge. Zur Verstärkung von Laserstrahlung beispielsweise im Wellenlängenbereich von 750 - 900 nm werden so vorzugsweise GaAlAs oder InGaAsP-Strukturen verwendet, über 900 um bis ca. 1120 nm InAsP, InGaAs oder InGaAsP-Materialien. GaAsP ist besonders auch zur Verstärkung im Wellenlängenbereich um 630 nm geeignet. Die Auswahl der Halbleiter-Verstärkermaterialien richtet sich nach dem konkreten Wellenlängenbereich der zu erzeugenden Laserstrahlung. Interessant sind hier sowohl Materialkombinationen der ternären Verbindungen (also entlang der Linien) wie auch quarternärer Verbindungen (also im Zwischenbereich 7wischen den Linien).

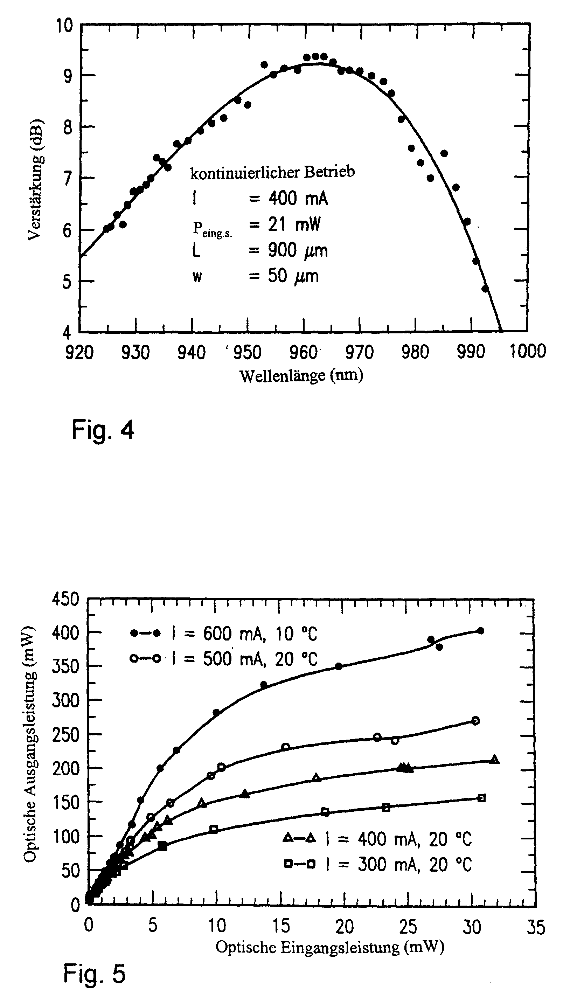

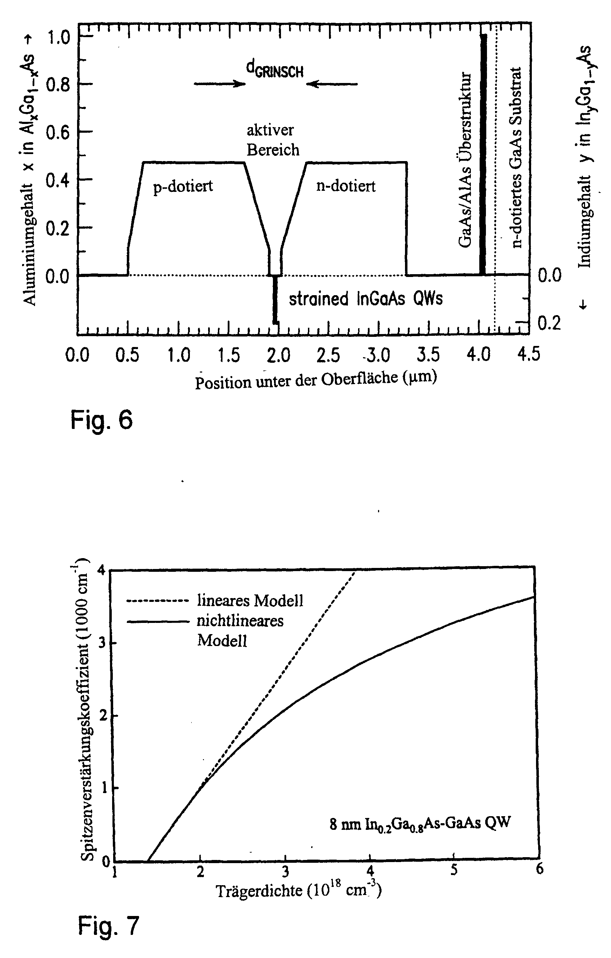

Die Verstärkungskurve solcher Halbleiterverstärker ist typisch 50-60 nm breit (Fig. 4, entnommen aus Ebeling/Unger, Zusammenfassung zum 2. Zwischenbericht F+E-Förderkennzeichen 13 N 6374/3, Universität Ulm), ihr Schwerpunkt kann durch Wahl der Dicke der Epitaxieschicht (Breite des Quantenfilms QW) und Dotierung der Materialien entsprechend eingestellt werden. Fig. 5 (entnommen ebenda) zeigt eine typische Schichtenfolge für einen In-GaAs-Verstärker. Durch die Breite des Quantenfilms QW wird insbesondere auch auf die Trägerdichte (Carrier Concentration) Einfluß genommen, welche den Verstärkungschwerpunkt beeinflußt (Fig. 6, entnommen ebenda). Die Verstärkung solcher Halbleiterstrukturen, welche vorzugsweise elektrisch durch Ladungsträger-Injektion gepumpt werden, ist im allgemeinen ausgesprochen effizient und beträgt typisch 50%, die erforderliche Sättigungsintensität zur Erzeugung von Laserstrahlung im Wattbereich typisch 5-10 mW (Fig 7, entnommen ebenda).

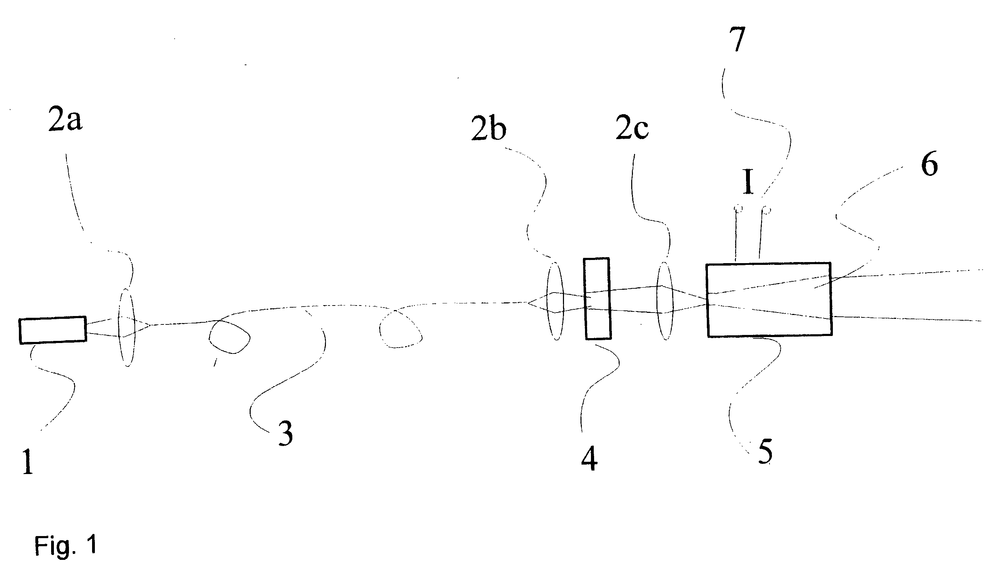

Fig. 1 zeigt ein solches Ausführungsbeispiel eines diodengepumpten Festkörperlasers, bestehend aus Pumplaserdiode 1 (deren Strahlung gegebenenfalls über eine Lichtleitfaser 3 übertragen wird) und Festkörper-Lasermaterial 4, in diesem Beispiel als monolithisch mit den erforderlichen Spiegelschichten bedampfter Mikrokristall ausgeführt, dessen Strahlung in eine Halbleiter-Verstärkereinheit 5 eingekoppelt wird. Die für die jeweilige Ankopplung verwendeten optischen Elemente (Linsen) 2a-c sind ebenfalls eingezeichnet. Die eingezeichnete Lichtleitfaser zur Übertragung des Pumplichts zum Mikrokristall-Laser wie auch alle Linsen sind hier optional und können gegebenenfalls weggelassen werden.

Der Halbleiterverstärker 5 wird vorzugsweise elektrisch über eine entsprechende Zuleitung 7 gepumpt durch Injektion von Ladungsträgern in die pn-Grenzschicht. Die räumliche Struktur 6 des Verstärkers kann vorzugsweise entweder quaderförmig (Breitstreifen) oder wie in der Figur beispielhaft eingezeichnet trapezförmig sein, letzteres mit dem Vorteil einer besseren Strahlqualität am Verstärkerausgang. Zur Fokussierung können hier Linsen oder andere Elemente mit linsenähnlichen Eigenschaften (Hologramme, Stablinsen etc.) verwendet werden. Als Festkörperlaser werden vorzugsweise miniaturisierte diodengepumpte Festkörperlaser wie Mikrokristall-Laser, monolithische Ringlaser oder generell longitudinal gepumpte Laser verwendet. Da das Halbleiterelement nur als Verstärker, also nicht in Resonanz betrieben wird, bleibt die Schmalbandigkeit der Laserlinie in erster Ordnung erhalten. Somit wird durch die Kombination der guten Lasereigenschaften von Festkörperlasern mit der hohen und effizienten Verstärkung elektrisch gepumpter Halbleiterelemente ein miniaturisiertes, effizientes Lasersystem geschaffen, das Ausgangsleistungen im Wattbereich bei ausgesprochen geringer Laserlinienbreite erzeugt.

Der Mikrokristall-Laser als Oszillator stellt hierbei eine besonders bevorzugte erfindungsgemäße Ausführung dar, da er neben ausgezeichneten Lasereigenschaften, wie sie gerade für die externe Frequenzverdopplung erforderlich sind (schmale Linienbreite bis zu 40 Hz, ausgezeichnetes Strahlprofil M² typisch < 1.2; vergl. Schmitt), insbesondere auch bereits stark miniaturisiert ist. Typische Abmessungen des gesamten Mikrokristall-Lasers (ohne Pumpdiode und Ankopplungsoptik), welcher beispielsweise aus einem monolithisch bedampften Kristallstück besteht, betragen 2-3 mm Durchmesser und typsich200-700 µm Dicke; der Durchmesser kann weiter auf 1 mm reduziert werden. Damit ist der Mikrokristall-Laser in der Größenordnung der Halbleiter-Verstärkerstrukturen (typisch einige 100 µm in zwei lateralen Dimensionen und 50-100 µm in der Dicke) und kann so leicht mit diesem in ein gemeinsames Gehäuse gebracht werden, was sowohl der Kostenreduktion bei der Herstellung als auch der Miniaturisierung des Lasersystems entgegenkommt. Die Pumplaserdiode (die typisch ebenfalls einige 100 µm in jeder Dimension sowie 50-100 µm in der Dikke mißt) sowie die Koppeloptiken können entweder ebenfalls in das Gehäuse eingebracht werden oder aber die Pumplaserdiode wird über eine Lichtleitfaser gekoppelt und in einem separaten Gehäuse angeordnet sein, wobei letzteres die Austauschbarkeit verbessert. Der Mikrokristall-Laser wie auch die Koppeloptiken können seitlich metallisiert sein und somit ebenso wie der Halbleiter-Verstärker sowie gegebenenfalls die Pumplaserdiode in ein Hybridgehäuse gelötet werden.

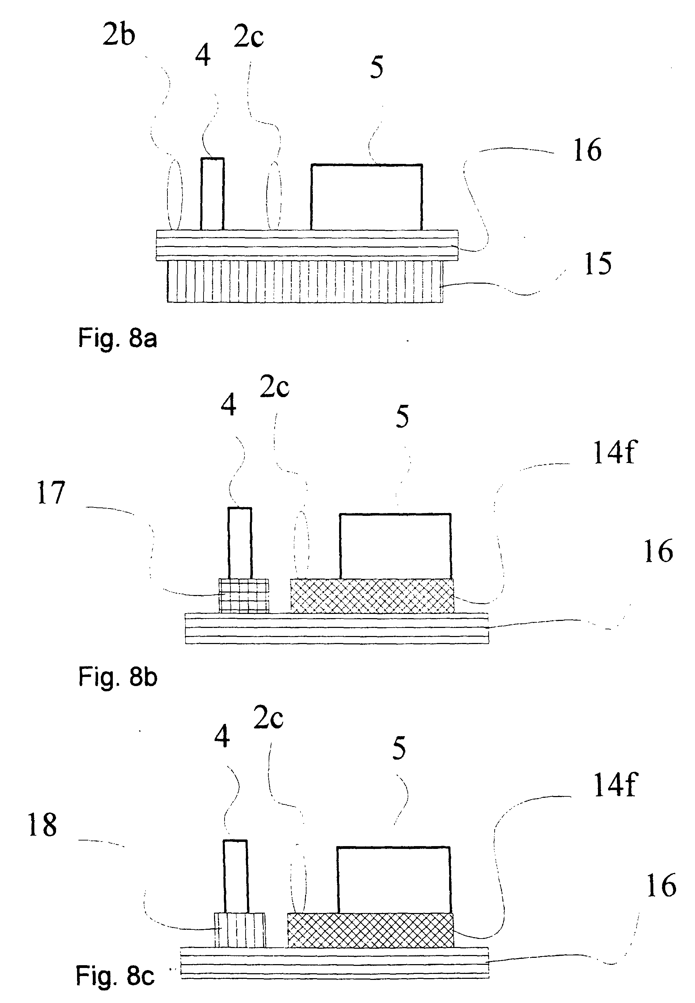

In besonderen Ausführungen können auch Mikrokristall-Laser 4 und Halbleiterverstärker 5 beispielsweise auf dieselbe Wärmesenke 16 montiert werden (Fig. 8a), welche dann durch ein Temperierelement 16 gemeinsam temperiert wird und was eine wesentliche Erhöhung der mechanischen Stabilität ermöglicht.

Anstatt des Mikrokristall-Lasers, dessen Funktionsprinzip darin besteht, dass der Resonator der Länge L hinreichend kurz ist, so dass nur eine einzige longitudinale Resonatormode im Verstärkungsbereich δν des Lasermateriales liegt, geschrieben als L < c/(.n. δν) (n ist der Brechungsindex des resonatorinternen Mediums; vergl. N.

Schmitt, Abstimmbare Festkörperlaser), können aber prinzipiell auch andere miniaturisierte, frequenzstabile Einfrequenzlaser verwendet werden. Dies können beispielsweise diodengepumpte Laser mit hochdotierten Materialien sein, welche in der Nähe des eines Spiegels angebracht sind und so das räumliche "Lochbrennen" vermieden wird (vergl. G. J. Kintz et. al, IEEE J. Quant. Electron. 26 (1990)1457). Weiter können es auch monolithische Ringlaser sein, wie etwa in T. J. Kane, Opt. Lett. 10 (1985) 65, beschrieben.

Für die Anwendungen der kohärenten Kommunikation beispielsweise zwischen Satelliten ist es in der Regel erforderlich, den Laser über mehrere 10 GHz einfrequent abzustimmen, um die Dopplerverschiebung zwischen den sich gegeneinander bewegenden Satelliten auszugleichen. Hier bieten abstimmbare Mikrokristall-Laser entscheidende Vorteile, da hier einfrequente Abstimmbereiche von über 130 GHz erreicht werden können (vergl. N.Schmitt, Abstimmbare Mikrokristall-Laser, S.143). Hier kann die Abstimmung entweder thermisch erfolgen, wobei die Temperatur des Mikrokristalls entsprechend verändert wird, oder durch ein bewegliches Spiegelelement des Lasers. Im Falle der thermischen Abstimmung empfiehlt es sich, den Mikrokristall, welcher mit einem Heiz- und/oder Kühlelement versehen ist, je nach Anordnung des Heiz-/Kühlelementes auf eine vom Halbleiterverstärker getrennte Wärmesenke bzw. ein unterschiedliches Temperaturniveau zu montieren (beispielhaft in Fig. 8b und 8c unter Verwendung eines thermisch schlecht leitenden Materials 17 bzw. eines Peltierelementes 18 skizziert). Es muß dann eine gemeinsame Basis geschaffen werden, welche eine Fixierung des Mikrokristalls in Bezug auf den Halbleiterchip ermöglicht.

Zur kohärenten Kommunikation ist es erforderlich, das Lasersignal in seiner Frequenz, Amplitude oder insbesondere Phase zu modulieren. Herkömmliche Modulatoren erlauben es derzeit nicht, Laserleistungen im Wattbereich zu modulieren. Hier ermöglicht das vorgeschlagene Konzept, den Modulator zwischen Festkörperlaser und Halbleiterverstärker anzuordnen, was einen weiteren wesentlichen Vorteil desselben darstellt. Dies ist in Fig . 9 dargestellt. Bei dem Modulator 10 handelt es sich zur Reduktion der Baugröße vorzugsweise um einen integriert-optischen Modulator, beispielsweise als Wellenleiter 11 mit Elektroden 12a.b versehen in LiNbO3 ausgebildet, oder um einen Fasermodulator.

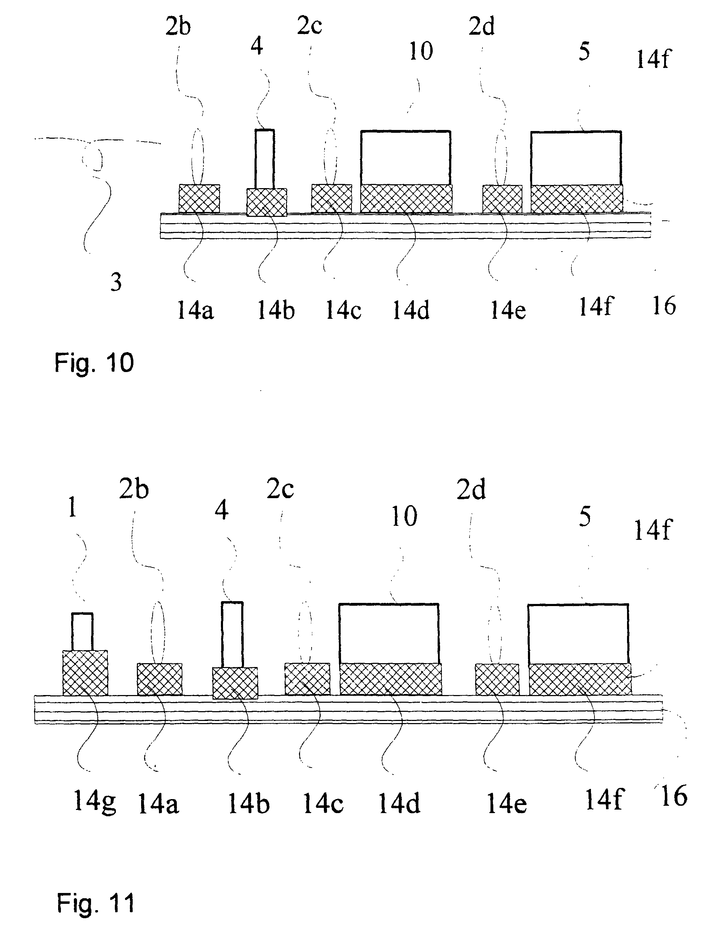

Hierbei ist es vorteilhaft, Festkörperlaser 4, Modulator 10 und Halbleiterverstärker 5 auf eine einzige Grundplatte 16 anzubringen, um eine Dejustage zu vermeiden (Fig. 10). Die einzelnen Elemente können dabei auf Montagesockeln, Temperierelementen und/oder Lotschichten 14a... (bzw. aus Kombinationen hieraus) sitzen, welche ggfs. auch die für eine lineare optische Kopplung erforderliche Höhenangleichung vornehmen.

Eine besonders miniaturisierte, mechanisch stabile und kostengünstig fertigbare Lösung erhält man, indem sowohl die Laserdiode 1, der (Mikrokristall-)Laser 4, gegebenenfalls der Modulator 10 und der Halbleiterverstärker 5 auf einer gemeinsamen Basis 16 (Möntageplatte) untergebracht sind (Fig. 11).

Statt der Verwendung eines externen Modulators 10 kann zumindest für manche Modulationsarten auch der Strom zum Pumpen des Halbleiterverstärkers oder der Pumpdiode moduliert werden.

Zusammenfassend wird ein System vorgestellt, welches
durch Verwendung eines vorzugsweise diodengepumpten Festkörperlasers die Erzeugung sehr schmalbandiger Laserstrahlung,
durch Verwendung eines Halbleiterverstärkers im Wattbereich ermöglicht, weiter
durch Verwendung des Halbleiterverstärkers (und vorzugsweise eines Mikrokristall-Lasers) ausgesprochen effizient und miniaturisiert ist und
durch Verwendung eines Modulators zwischen Festkörperlaser und Halbleiterlaser eine Amplituden-, Phasen- und/oder Frequenzmodulation erlaubt.

## Patentansprüche

1. Einfrequentes Laser- und Verstärkungssystem mit einem Festkörperlaser **(4)** und einem damit optisch gekoppelten Halbleiterverstärker-Chip **(5),** welcher durch Wahl des Materialsystems sowie der epitaktischen Strukturierung auf die Emissionswellenlänge des Festkörperlasers **(4)** angepasst ist und somit einen gegenüber der eingekoppelten Festkörperlaserstrahlung verstärkte Ausgangsstrahl erzeugt,
**dadurch gekennzeichnet,**
**dass** als Festkörperlaser **(4)** ein Mikrokristall-Laser oder ein miniaturisierter Laser mit kurzer Resonatorlänge oder ein monolithischer Ringlaser eingesetzt wird, wobei die Abmessungen des jeweiligen Festkörperlasermaterials und des zugehörigen Resonators in der Grössenordnung des Halbleiterverstärker-Chips **(5)** liegen, derart dass der Festkörperlaser **(4)** einfrequente, schmalbandige Laserstrahlung erzeugt, welche in den Halbleiterverstärker-Chip **(5)** eingekoppelt wird.

2. Laser- und Verstärkersystem nach Anspruch **1, dadurch gekennzeichnet, dass** der Halbleiterverstärker-Chip(5) elektrisch gepumpt ist.

3. Laser- und Verstärkersystem nach Anspruch **1** oder **2, dadurch gekennzeichnet, dass** zwischen Festkörperlaser **(4)** und Halbleiterverstärker-Chip **(5)** ein Modulator **(10)** eingebracht ist, welcher die Phase oder Frequenz der Festkörperlaserstrahlung moduliert.

4. Laser- und Verstärkersystem nach einem der Ansprüche **1** bis **3, dadurch gekennzeichnet, dass** es zur kohärenten Kommunikation zwischen Satelliten ausgebildet ist.

5. Laser- und Verstärkersystem nach einem der Ansprüche **1** bis **4, dadurch gekennzeichnet, dass** der Festkörperlaser **(4)** fest mit dem Halbleiterverstärker-Chip **(5)** kontaktiert ist.

6. Laser- und Verstärkersystem nach einem der Ansprüche **1** bis **5, dadurch gekennzeichnet, dass** der Festkörperlaser **(4)** und der Halbleiterverstärker-Chip (5) auf derselben Wärmesenke **(16)** oder auf einer gemeinsamen Basis angeordnet sind.

7. Laser- und Verstärkersystem nach Anspruch **6, dadurch gekennzeichnet, dass** auch ein zwischen Festkörperlaser **(4)** und Halbleiterverstärker-Chip **(5)** befindlicher Modulator **(10)** sowie zur Kopplung erforderliche Linsen **(2c; 2e)** und eine Pumplaserdiode **(1)** für den Festkörperlaser **(4)** nebst erforderlichen Kopplungslinsen (**2a; 2b**) auf der gemeinsamen Basis oder Wärmesenke **(16)** angeordnet sind.

8. Laser- und Verstärkersystem nach Anspruch **6** oder **7, dadurch gekennzeichnet, dass** zwischen den einzelnen Elementen und der Basis mechanische Halter, Temperierelemente und/oder Lotschichten angeordnet sind.

9. Laser- und Verstärkersystem nach einem der Ansprüche **1** bis **5, dadurch gekennzeichnet, dass** der Festkörperlaser **(4)** auf einer vom Halbleiterverstärker-Chip **(5)** getrennten Wärmesenke angebracht ist und am Festkörperlaser **(4)** und Wärmesenke ein Heiz- und/oder Kühlelement angebracht ist, welches eine thermisch induzierte Frequenzabstimmung der Festkörperlaserstrahlung erlaubt.

10. Laser- und Verstärkersystem nach einem der Ansprüche **1** bis **9, dadurch gekennzeichnet, dass** eine Modulation der verstärkten Laserstrahlung durch eine Strommodulation des Halbleiterverstärker-Chips **(5)** erzeugt wird.

11. Laser- und Verstärkersystem nach einem der Ansprüche **2** bis **10, dadurch gekennzeichnet, dass** eine Phasen- oder Frequenzmodulation des Festkörperlasers **(4)** durch eine Strommodulation einer oder der ihn pumpenden Pumplaserdiode **(1)** erzeugt wird.

12. Laser- und Verstärkersystem nach einem der Ansprüche **1** bis **11, dadurch gekennzeichnet, dass** der Halbleiterverstärker-Chip **(5)** eine quaderförmige oder trapezförmige verstärkende Struktur aufweist.

13. Laser- und Verstärkersystem nach einem der Ansprüche **1** bis **12, dadurch gekennzeichnet, dass** das Materialsystem, die Strukturierung und die Abmessungen derart gewählt sind, dass die Strahlung des verstärkten Ausgangsstrahls eine Linienbreite < 10 kHz aufweist.

14. Laser- und Verstärkersystem nach einem der Ansprüche **3** bis **13, dadurch gekennzeichnet, dass** der Modulator **(10)** ein Fasermodulator oder ein integriert-optischer als Wellenleiter **(11)** mit Elektroden **(12a, b)** versehen in LiNbO3 ausgebildeter Modulator ist.

## Claims

1. A single-frequency laser and amplification system comprising a solid-state laser **(4)** and a semiconductor amplifier chip **(5)** which is optically coupled thereto and which is adapted to the emission wavelength of the solid-state laser **(4)** by the selection of the material system and by epitaxial structuring, and which thus produces an output beam which is amplified in relation to the coupled-in solid-state laser radiation,
**characterised in that**
a micro-crystal laser or a miniaturised laser having a short resonator length, or a monolithic ring laser, is used as a solid-a state laser **(4)**, wherein the dimensions of the respective solid-state laser material and of the associated resonator are of the order of the semiconductor amplifier chip **(5)** so that the solid-state laser **(4)** generates single-frequency narrow band laser radiation which is coupled into the semiconductor amplifier chip **(5).**

2. A laser and amplifier system according to claim **1**, **characterised in that** the semiconductor amplifier chip **(5)** is electrically pumped.

3. A laser and amplifier system according to claims **1** or **2, characterised in that** a modulator **(10),** which modulates the phase or frequency of the solid-state laser radiation, is provided between the solid-state laser **(4)** and the semiconductor amplifier chip **(5).**

4. A laser and amplifier system according to any one of claims **1** to **3, characterised in that** it is constructed for coherent communication between satellites.

5. A laser and amplifier system according to any one of claims **1** to **4, characterised in that** the solid-state laser **(4)** is in fixed contact with the semiconductor amplifier chip **(5).**

6. A laser and amplifier system according to any one of claims **1** to **5, characterised in that** the solid-state laser **(4)** and the semiconductor amplifier chip **(5)** are disposed on the same heat sink **(16)** or on a common base.

7. A laser and amplifier system according to claim **6, characterised in that** a modulator **(10)** which is situated between the solid-state laser **(4)** and the semiconductor amplifier chip **(5),** as well as lenses **(2c; 2e)** which are necessary for coupling, and a pumped laser diode **(1)** for the solid-state laser **(4),** together with the requisite coupling lenses **(2a; 2b),** are also disposed on the common base or heat sink **(16).**

8. A laser and amplifier system according to claims **6** or **7, characterised in that** mechanical holders, temperature control elements and/or soldered layers are disposed between the individual elements and the base.

9. A laser and amplifier system according to any one of claims **1** to **5, characterised in that** the solid-state laser **(4)** is mounted on a heat sink which is separate from the semiconductor amplifier chip **(5)** and that a heating and/or cooling element is mounted on the solid-state laser **(4),** which element permits thermally induced frequency tuning of the solid-state laser radiation.

10. A laser and amplifier system according to any one of claims **1** to **9, characterised in that** modulation of the amplified laser radiation is effected by current modulation of the semiconductor amplifier chip **(5).**

11. A laser and amplifier system according to any one of claims **2** to **10, characterised in that** phase- or frequency modulation of the solid-state laser **(4)** is effected by current modulation of a pumped laser diode or of the pumped laser diode **(1)** which pumps it.

12. A laser and amplifier system according to any one of claims **1** to **11, characterised in that** the semiconductor amplifier chip **(5)** has a cuboidal or trapezoidal amplifying structure.

13. A laser and amplifier system according to any one of claims **1** to **12, characterised in that** the material system, structuring and dimensions are selected so that the radiation of the amplified output beam has a line width < 10 kHz.

14. A laser and amplifier system according to any one of claims **3** to **13, characterised in that** the modulator **(10)** is a fibre optic modulator or is an integrated optical modulator which is constructed as a waveguide **(11)** provided with electrodes **(12a, b)** in LiNbO₃.

## Revendications

1. Système de laser et d'amplificateur à une seule fréquence présentant un laser à l'état solide (4) et une puce d'amplificateur à semi-conducteurs (5) qui y est couplée optiquement, lequel est adapté, par le choix du système des matériaux et de la structure d'épitaxie, à la longueur d'onde d'émission du laser à l'état solide (4) et génère ainsi un faisceau en sortie amplifié par rapport au faisceau du laser à l'état solide entrant,
**caractérisé en ce que**
l'on utilise en tant que laser à l'état solide (4) un laser microcristallin ou un laser miniaturisé présentant une longueur de résonance courte ou un laser annulaire monolithique, les dimensions du matériau du laser à l'état solide respectif et du résonateur s'y rapportant étant de l'ordre de grandeur de la puce d'amplificateur à semi-conducteurs (5), de sorte que le laser à l'état solide (4) génère un faisceau laser de fréquence simple et à bande étroite qui est couplé en entrée dans la puce d'amplificateur à semi-conducteurs (5).

2. Système de laser et d'amplificateur selon la revendication 1, **caractérisé en ce que** la puce d'amplificateur à semi-conducteurs (5) est pompée électriquement.

3. Système de laser et d'amplificateur selon la revendication 1 ou 2, **caractérisé en ce qu'**est appliqué entre le laser à l'état solide (4) et la puce d'amplificateur à semi-conducteurs (5) un modulateur (10) qui module la phase ou la fréquence du faisceau du laser à l'état solide.

4. Système de laser et d'amplificateur selon l'une des revendications 1 à 3, **caractérisé en ce qu'**il est conçu pour la transmission cohérente entre des satellites.

5. Système de laser et d'amplificateur selon l'une des revendications 1 à 4, **caractérisé en ce que** le laser à l'état solide (4) est en contact étroit avec la puce d'amplificateur à semi-conducteurs (5).

6. Système de laser et d'amplificateur selon l'une des revendications 1 à 5, **caractérisé en ce que** le laser à l'état solide (4) et la puce d'amplificateur à semi-conducteurs (5) sont disposés sur le même dissipateur thermique (16) ou sur une base commune.

7. Système de laser et d'amplificateur selon la revendication 6, **caractérisé en ce que** sont également disposés sur la base commune ou sur le dissipateur thermique (16) un modulateur (10) disposé entre le laser à l'état solide (4) et la puce d'amplificateur à semi-conducteurs (5), ainsi que pour le couplage des lentilles nécessaires au couplage (2c ; 2^{e}) et une diode laser de pompage (1) pour le laser à l'état solide (4) en plus des lentilles de couplage nécessaires (2a ; 2b).

8. Système de laser et d'amplificateur selon la revendication 6 ou 7, **caractérisé en ce que** sont disposés des supports mécaniques, des éléments d'équilibrage et/ou des couches de brasage entre les différents éléments et la base.

9. Système de laser et d'amplificateur selon l'une des revendications 1 à 5, **caractérisé en ce que** le laser à l'état solide (4) est appliqué sur un dissipateur thermique séparé d'une puce d'amplificateur à semi-conducteurs (5) et **en ce qu'**est appliqué sur le laser à l'état solide (4) et le dissipateur thermique un élément de chauffage et/ou de refroidissement, qui permet un accord en fréquence induit thermiquement du faisceau laser à l'état solide.

10. Système de laser et d'amplificateur selon l'une des revendications 1 à 9, **caractérisé en ce qu'**une modulation du faisceau laser amplifié est générée par une modulation en courant de la puce d'amplificateur à semi-conducteurs (5).

11. Système de laser et d'amplificateur selon l'une des revendications 2 à 10, **caractérisé en ce qu'**une modulation en phase ou en fréquence du laser à l'état solide (4) est générée par une modulation en courant d'une ou de la diode laser de pompage qui le pompe (1).

12. Système de laser et d'amplificateur selon l'une des revendications 1 à 11, **caractérisé en ce que** la puce d'amplificateur à semi-conducteurs (5) présente une structure d'amplification en forme de parallélépipède ou de trapèze.

13. Système de laser et d'amplificateur selon l'une des revendications 1 à 12, **caractérisé en ce que** le système des matériaux, la structuration et les dimensions sont sélectionnés de façon telle que le faisceau du faisceau de sortie amplifié présente une largeur de raie < 10 kHz.

14. Système de laser et d'amplificateur selon l'une des revendications 3 à 13, **caractérisé en ce que** le modulateur (10) est un modulateur à fibre ou un modulateur à optique intégrée conçu en tant que guide d'onde (11) présentant des électrodes (12a, b) en LiNbO3.
